**Europäisches Patentamt**

**European Patent Office**

**Office européen des brevets**

(19)

(11) Veröffentlichungsnummer : **0 389 868 B1**

(12)

# EUROPÄISCHE PATENTSCHRIFT

(45) Veröffentlichungstag der Patentschrift :
**13.09.95 Patentblatt 95/37**

(51) Int. Cl.$^6$ : **G01R 33/36**

(21) Anmeldenummer : **90104825.6**

(22) Anmeldetag : **14.03.90**

(54) **Kernspintomograph.**

(30) Priorität : **29.03.89 DE 3910187**

(43) Veröffentlichungstag der Anmeldung :
**03.10.90 Patentblatt 90/40**

(45) Bekanntmachung des Hinweises auf die
Patenterteilung :
**13.09.95 Patentblatt 95/37**

(84) Benannte Vertragsstaaten :
**DE GB**

(56) Entgegenhaltungen :
**EP-A- 0 094 734
EP-A- 0 257 782
EP-A- 0 262 495
EP-A- 0 301 232**

(56) Entgegenhaltungen :
**DE-A- 3 237 250
US-A- 4 742 304
US-A- 4 792 759
MEDICAL PHYSICS, Band 13, Nr. 4, Juli/August 1986, Seiten 510-513, Am. Assoc.Phys. Med., New York, US; M.O. LEACH et al.: "The design and use of a dual-frequency surface coil providing proton images for improved localization in 31P spectroscopy of small lesions"**

(73) Patentinhaber : **SIEMENS AKTIENGESELLSCHAFT
Wittelsbacherplatz 2
D-80333 München (DE)**

(72) Erfinder : **Dürr, Wilhelm Dr.
Damaschkestrasse 99
D-8520 Erlangen (DE)**

EP 0 389 868 B1

**Beschreibung**

Die Erfindung bezieht sich auf einen Kernspintomographen mit einer einen Wellenleiterresonator bildenden Hochfrequenzantenne gemäß dem Oberbegriff des Anspruchs 1. Ein derartiger Kernspintomograph geht aus der EP-A-0 073 375 hervor.

Auf dem Gebiet der medizinischen Diagnostik werden bekanntlich sogenannte Kernspintomographen verwendet, bei denen durch rechnerische oder meßtechnische Analyse integraler Protonenresonanzsignale aus der räumlichen Spindichte - oder auch der Relaxaxionszeitenverteilung eines zu untersuchenden Körpers - ein Bild ähnlich einem Röntgentomogramm konstruiert wird. Der zu untersuchende Körper, insbesondere ein menschlicher Körper, wird in ein starkes homogenes Magnetfeld, das sogenannte Grundfeld, eingebracht, das die Kernspins im menschlichen Körper ausrichtet. Ferner sind Gradientenspulen vorgesehen, die ein räumlich unterschiedliches Magnetfeld erzeugen. Eine Hochfrequenzantenne regt die Kernspins an und empfängt das von den angeregten Kernspins emittierte Signal. Diese Hochfrequenzantenne ist im allgemeinen über Anpassungskapazitäten sowie eine Sende-und Empfangsweiche an einen Sender und einen Empfänger angeschlossen.

In einer bekannten Ausführungsform eines Kernspintomographen enthält die Hochfrequenzantenne eine hochfrequenzdichte und niederfrequenzdurchlässige zylindrische Hülle aus elektrisch gut leitendem Material, die wenigstens zwei sich parallel zur Zylinderachse erstreckende Innenleiter umgibt. Innenleiter und Hülle sind an einem Sender und einem Empfänger angeschlossen. Die Innenleiter sind mit sogenannten Verkürzungskapazitäten derart abgeschlossen, daß die Induktivität der Innenleiter mit diesen Verkürzungskapazitäten einen Wellenleiterresonator bildet. Die Leiterpaare ermöglichen innerhalb der Hülle eine Wellenausbreitung mit hoher Frequenz von beispielsweise 100 MHz, wobei Resonanzverhältnisse eingestellt werden, so daß im Abbildungsvolumen gleichphasig schwingende Felder entstehen und auf den Innenleitern stehende Wellen ausgebildet werden. Die Innenleiter werden durch die Verkürzungskapazitäten auf eine Länge begrenzt, die etwa dem Untersuchungsobjekt, d.h. der Größe eines menschlichen Körpers entspricht. Die Hülle stellt neben einem Leitkörper für das Hochfrequenzfeld zugleich eine Hochfrequenz-Abschir mung gegenüber äußeren Bauteilen dar. Dagegen können sich aufgrund der Niederfrequenzdurchlässigkeit der Hülle, deren Dicke vorzugsweise weniger als 100 µm beträgt, im Abbildungsvolumen die niederfrequenten Gradientenfelder weitgehend ungehindert ausbreiten. Die Hochfrequenzantenne ist jeweils für eine Resonanzfrequenz bemessen (vgl. die genannte EP-A-0 073 375).

Die Hochfrequenzantennen in Kernspintomographen sind in der Regel für Protonenbildgebung vorgesehen. Es wird jedoch zunehmend gefordert, auch andere Atome, beispielsweise Phosphor, Fluor oder Natrium, in derselben Anlage untersuchen zu können. Da diese Atomkerne sehr unterschiedliche Kernspinresonanzen aufweisen, könnten sie nur mit einer entsprechend breitbandigen Hochfrequenzantenne untersucht werden. Eine breitbandige Ausführungsform der Hochfrequenzantenne kann aber wegen der Forderung nach geringen Systemverlusten nur mit unzulässig hohem Aufwand hergestellt werden. Zur Untersuchung verschiedener Atomkerne wurden deshalb bisher auch verschiedene Hochfrequenzantennen verwendet. Bei Verwendung von Hochfrequenzantennen mit verhältnismäßig geringer Ausdehnung, beispielsweise Oberflächen- und Kopfspulen, können diese ohne großen Aufwand ausgetauscht werden. Dagegen ist dies bei Ganzkörperresonatoren praktisch nicht möglich; diese werden somit nur zur Untersuchung vorbestimmter Atome, beispielsweise ausschließlich für Protonenexperimente, eingesetzt.

Der Erfindung liegt nun die Aufgabe zugrunde, für einen Kernspintomographen gemäß dem Oberbegriff des Anspruchs 1 die Bauform eines Ganzkörperresonators in der Form eines kapazitiv verkürzten Wellenleiterresonators anzugeben, der für mehrere Resonanzfrequenzen und somit auch zur Untersuchung verschiedener Atome verwendet werden kann.

Diese Aufgabe wird erfindungsgemäß gelöst mit den kennzeichnenden Merkmalen des Anspruchs 1.

Aus "Medical Physics", Vol. 13, No. 4, 1986, Seiten 510 bis 513 ist eine Ausführungsform einer Hochfrequenz-Oberflächenspule eines Kernspintomographen zu entnehmen, die für zwei verschiedene Resonanzfrequenzen ausgelegt ist. Hierzu ist das eine Ende der einen kleinen Untersuchungsbereichs erfassenden Spule mit zwei getrennten Eingängen verbunden, die für jeweils eine der beiden Resonanzfrequenzen bestimmt sind. Der Eingang für die niedrigere Resonanzfrequenz ist bezüglich der höheren Resonanzfrequenz mittels eines besonderen Entkopplungskreises entkoppelt. Das andere Ende der Oberflächenspule ist direkt auf Massepotential gelegt. Eine solche Spule mit einer nahezu diskreten felderzeugenden Induktivität L läßt sich jedoch von ihrem Aufbau und ihrer Verschaltung her nicht mit einem Wellenleiterresonator vergleichen. Sie weist nämlich keine langgestreckten Leiterpaare mit Verkürzungskapazitäten sowie keine zylindrische Hülle auf.

In dem Kernspintomographen nach der Erfindung besteht der bei mehreren Frequenzen angepaßte Resonator für eine linear polarisierte Antenne aus mindestens zwei Innenleitern und für eine zirkular polarisierte Antenne aus mindestens vier Innenleitern. In einer Ausführungsform des Resonators werden Leitersysteme mit unterschiedlichen Resonanzfrequenzen ineinander verschachtelt. Die induktive Verkopplung läßt sich dabei durch Sperrkreise für die nicht gewünschten Frequenzen vermeiden, die dazu an wenigstens einem Ende der Innenleiter in Reihe mit den Verkürzungskondensatoren angeordnet werden. Die Auswirkungen kapazitiver Verkopplung der Innenleiter lassen sich durch weitere Sperrkreise am anderen Ende der Innenleiter praktisch vermeiden.

Auf der Eingangsseite können die Sperrkreise direkt an die Innenleiter angeschlossen werden. Damit erreicht man eine Entkopplung der beiden Eingänge.

In einer besonderen Ausführungsform des Kernspintomographen hat der Wellenleiterresonator für mehrere Resonanzfrequenzen und feste Kopplung nur ein Paar von Innenleitern, die auch noch mehrere Verkürzungskapazitäten enthalten können.

Die Sperrkreise sind Parallelschwingkreise für die zu sperrende Resonanzfrequenz, die insbesondere als Leitungskreise ausgeführt werden können. Sind die Sperrkreise gegen Masse geschaltet, so können insbesondere Koaxialleitungskreise vorgesehen sein, deren Schirm auf Masse gelegt ist.

Zur weiteren Erläuterung der Erfindung wird auf die Zeichnung Bezug genommen, in deren Figur 1 ein Wellenleiterresonator als Ganzkörperantenne für einen Kernspintomographen schematisch veranschaulicht ist. In Figur 2 ist eine Ausführungsform eines Wellenleiterresonators für verschiedene Frequenzen als Blockschaltbild schematisch dargestellt. Die Figuren 3 und 4 zeigen jeweils eine vereinfachte Ausführungsform des Wellenleiterresonators. In den Figuren 5 bis 7 ist jeweils eine Ausführungsform der Sperrkreise veranschaulicht. Die Figuren 8 bis 10 zeigen jeweils eine besondere Ausführungsform der Ankopplung des Wellenleiterresonators an Sender und Empfänger.

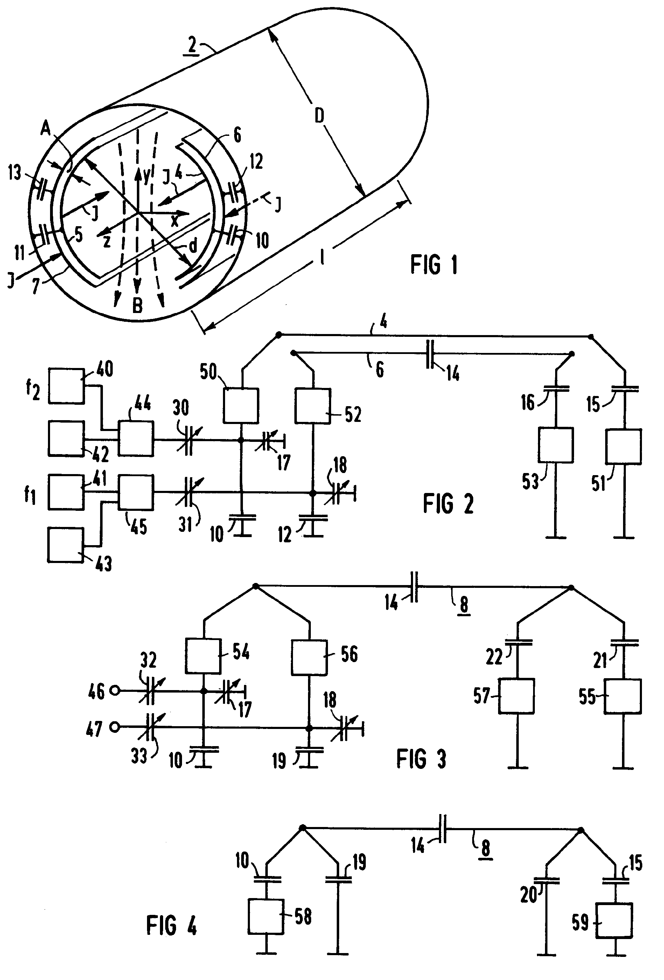

In der Ausführungsform einer Hochfrequenzantenne für einen Kernspintomographen als Wellenleiterresonator gemäß Figur 1 ist eine käfigartige hohlzylinderförmige Hülle 2 vorgesehen, deren Zylinderachse in Richtung der z-Koordinate eines rechtwinkligen x-y-z-Koordinatensystems orientiert ist. Diese Hülle mit einer Länge L von beispielsweise etwa 200 cm und einem Durchmesser D von beispielsweise etwa 70 cm kann beispielsweise aus Kupfer oder auch wenigstens teilweise versilbertem Kupfer bestehen. Ferner kann sie aus Kunststoff bestehen, das auf wenigstens einer Seite metallisiert, beispielsweise verkupfert oder versilbert, ist. Die Hülle 2 umschließt vier Innenleiter 4 bis 7, von denen jeweils zwei ein Leitersystem bilden und in der Figur mit 4 und 5 bzw. 6 und 7 bezeichnet sind. Diese Innenleiter 4 bis 7 sind parallel zur Zylinderachse in einem Abstand A voneinander angeordnet, der beispielsweise etwa 2 cm betragen kann. Das Leitersystem mit den Innenleitern 6 und 7 ist vom Zylinder 2 etwa 3 cm entfernt, so daß die inneren Innenleiter 6 und 7 einen Untersuchungsraum mit einem Durchmesser d von etwa 60 cm einschließen. Mit diesen von der Leiterhülle 2 umgebenen Leitersystemen wird ein durch gestrichelte Pfeile angedeutetes hochfrequentes Magnetfeld B erzeugt, das in der Nähe der Zylinderachse weitgehend homogen und senkrecht zur Z-Achse gerichtet ist. Die Leiter 4 bis 7 sind wenigstens an einem Ende mit wenigstens einer Verkürzungskapazität, vorzugsweise mit mehreren Verkürzungskapazitäten, versehen, von denen in der Figur zur Vereinfachung nur eine dargestellt und beispielsweise für den Innenleiter 4 mit 10 bezeichnet ist. In gleicher Weise sind die übrigen Innenleiter mit Verkürzungskapazitäten 11 bis 13 versehen. Diese Kapazitäten bilden jeweils mit der Induktivität des ihnen zugeordneten Innenleiters einen Wellenleiterresonator. Die Stromrichtung der Innenleiter 4 und 5 sowie 6 und 7 ist in der Figur jeweils durch einen Pfeil bezeichnet. Die Zuleitung für die Wellenleiterresonatoren und die Ankopplung der Innenleiter 4 bis 7 an getrennte Sender und Empfänger ist in der Figur nicht dargestellt.

Diese Ankopplung der Innenleiter 4 und 6 an jeweils einen Sender 40 bzw. 41 und einem Empfänger 42 bzw. 43 ist in Figur 2 schematisch veranschaulicht. Der Innenleiter 4 für eine tiefe Resonanzfrequenz, beispielsweise $f_2 = 69$ MHz zur Untersuchung von Phosphor, ist am Anfang mit wenigstens einer Verkürzungskapazität 10 versehen. Auch am Ende können mehrere Verkürzungskapazitäten vorgesehen sein, von denen in der Figur zur Vereinfachung lediglich eine dargestellt ist und mit 15 bezeichnet ist. Der Innenleiter 4 enthält ferner am Anfang in Reihe mit der Verkürzungskapazität 10 einen Sperrkreis 50 für die hohe Resonanzfrequenz, beispielsweise $f_1 = 170$ MHz, und am Ende in Reihe mit der Verkürzungskapazität 15 einen gleichen Sperrkreis 51. In gleicher Weise ist mit den gegebenenfalls vorhandenen, jedoch in der Figur nicht dargestellten weiteren Verkürzungskapazitäten ein Sperrkreis in Reihe geschaltet. Der Sender 40 ist über eine Sende- und Empfangsweiche 44 sowie eine Anpassungskapazität 30 an den Verbindungsleiter des Sperrkreises 50 mit der Verkürzungskapazität 10 angeschlossen. Der Verkürzungskapazität 10 kann vorzugsweise noch eine veränderbare zusätzliche Verkürzungskapazität 17 zur Abstimmung parallelgeschaltet sein. Der Innenleiter 6 für die hohe Resonanzfrequenz $f_1$ enthält vorzugsweise noch eine zusätzliche Verkürzungkapazität 14. Sein Anfang ist über einen Sperrkreis 52 für die tiefe Resonanzfrequenz $f_2$ und die Verkürzungskapazität 12 an Masse gelegt. Das Ende des Innenleiters 6 ist über Verkürzungskapazitäten, von denen in der Figur lediglich eine angedeutet und mit 16 bezeichnet ist, sowie einen Sperrkreis 53 für die tiefe Resonanzfrequenz $f_2$ ebenfalls an Masse gelegt. Die in der Figur angedeuteten Masseanschlüsse liegen vorzugsweise an der Hülle 2. Der dem Innenleiter 6 zugeordnete Sender 41 ist über eine Sende- und Empfangsweiche 45 sowie eine Anpassungskapazität 31 an den Verbindungsleiter zwischen dem Sperrkreis 52 und der Verkürzungskapazität 12 angeschlossen. Eine zur Abstimmung vorzugsweise vorgesehene Verkürzungskapazität ist in der Figur mit 18 bezeichnet. An die Sende- und Empfangsweichen 44 und 45 ist ferner jeweils ein Empfänger 42 bzw. 43 angeschlossen. Der Innenleiter 6 mit doppelt kapazitiver Verkürzung durch den zusätzlichen Verkürzungskondensator 14 eignet sich besonders für eine sehr hohe Resonanzfrequenz.

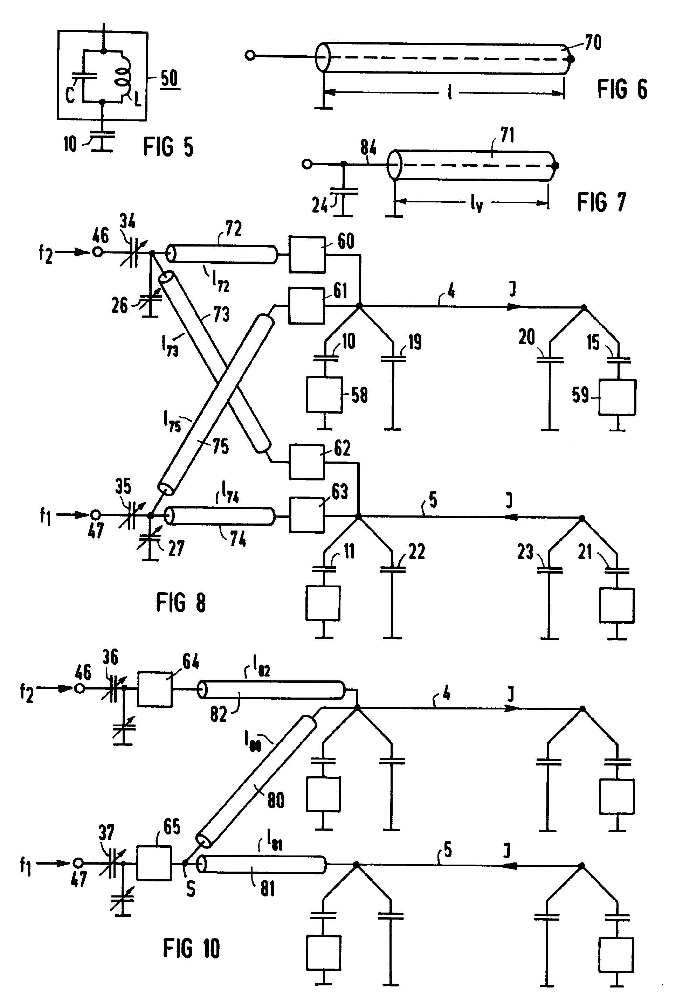

In einer besonders vorteilhaften Ausführungsform eines Kernspintomographen mit mehreren Betriebsfrequenzen gemäß Figur 3 ist für die beiden Resonanzfrequenzen ein gemeinsamer Innenleiter 8 vorgesehen, welcher vorzugsweise eine Verkürzungskapazität 14 in der Leitungsführung sowie auch noch zusätzliche, in der Figur nicht dargestellte Verkürzungskapazitäten enthalten kann. Dieser Innenleiter 8 ist am Anfang und am Ende mit Mitteln zur getrennten Steuerung der Ströme für beide Resonanzfrequenzen $f_1$ und $f_2$ versehen. Zu diesem Zweck ist der Anfang über Sperrkreise 54 und 56 sowie Verkürzungskapazitäten 10 bzw. 19 und das Ende über Sperrkreise 55 und 57 und die Verkürzungskapazitäten 21 bzw. 22 jeweils an Masse angeschlossen. Sender und Empfänger werden jeweils an einen Eingang 46 bzw. 47 angeschlossen. Die Eingangsleitungen enthalten jeweils eine Anpassungskapazität 32 bzw. 33. Die Ströme im Innenleiter 8 sind vorgegeben durch die Impedanz der Sperrkreise 54 und 56 sowie 55 und 57. In jeweils zwei Sperrkreisen, beispielsweise den Sperrkreisen 54 und 55 für die hohe Frequenz $f_1$, wird die Frequenz des anderen Stromkreises gesperrt. Wenn beispielsweise diese Sperrkreise 54 und 55 sperren, so fließt in deren Stromzweigen nur ein Strom I mit der tiefen Frequenz $f_2$. Es ist auch ein Betrieb mit beiden Resonanzfrequenzen, d.h. zugleich sowohl mit der hohen Resonanzfrequenz $f_1$ als auch mit der tiefen Resonanzfrequenz $f_2$, möglich; denn in den anderen Stromzweigen mit den Sperrkreisen 56 und 57 für die tiefe Frequenz $f_2$ können Ströme mit der hohen Resonanzfrequenz $f_1$ fließen.

In der vereinfachten Ausführungsform gemäß Figur 4 ist ebenfalls der gemeinsame Innenleiter 8 mit seinen Verkürzungskapazitäten vorgesehen, von denen zur Vereinfachung nur jeweils eine dargestellt und mit 10 und 15 sowie mit 19 und 20 bezeichnet sind. Der Anfang ist über die Verkürzungskapazität 10 und einen Sperrkreis 58 an Masse gelegt. Ferner ist der Anfang über die Verkürzungskapazität 19 direkt an Masse gelegt. In gleicher Weise ist das Ende über die Verkürzungskapazität 20 direkt und über die Verkürzungskapazität 15 in Reihe mit dem Sperrkreis 59 an Masse gelegt. In dieser Ausführungsform sind die beiden Verkürzungskapazitäten 19 und 20 für die hohe Resonanzfrequenz $f_1$ bemessen. Die beiden Sperrkreise 58 und 59 sind ebenfalls für die hohe Resonanzfrequenz bemessen. Die beiden Zweige mit den Verkürzungskapazitäten 10 und 19 und dem Sperrkreis 58 sowie die beiden Zweige mit den Verkürzungskapazitäten 15 und 20 und dem Sperrkreis 59 bilden jeweils zusammen die Verkürzungskapazität für die geringere Resonanzfrequenz $f_2$. Bei der Dimensionierung der Kapazitäten 15 bzw. 10 für die tiefe Frequenz $f_2$ sind die Kapazitäten 20 bzw. 19 sowie die Impedanzen der Sperrkreise 59 bzw. 58 zu berücksichtigen. In dieser Ausführungsform werden somit zwei Sperrkreise eingespart.

Die Sperrkreise enthalten einen Parallelschwingkreis, wie es in Figur 5 angedeutet ist, in welcher der Sperrkreis 50 in Reihe mit der Verkürzungskapazität 10 gewählt ist. Seine Induktivität L und die Kapazität C sind so bemessen, daß er eine hohe Schwingkreisimpedanz Z bei der Resonanzfrequenz hat, die er sperren soll. Die maximale Schwingkreisimpedanz Z ist abhängig von den Verlusten bei der Resonanzfrequenz, beispielsweise der Resonanzfrequenz

$$f_1 = \frac{1}{2\pi\sqrt{LC}} .$$

Die Resonanzfrequenz $f_1$ oder $f_2$ des Sperrkreises ist somit für die Resonanzfrequenz des benachbarten Zweiges bemessen, die er sperren soll. Der Sperrkreis 59 sperrt beispielsweise die höhere Resonanzfrequenz $f_1$ im Stromkreis für die tiefere Resonanzfrequenz $f_2$.

Die Sperrkreise können gemäß Figur 6 vorzugsweise als Leitungskreis, insbesondere mit einem am Ende kurzgeschlossenen Koaxialleiter 70, aufgebaut werden. Diese Ausführungsform mit dem Koaxialleiter 70, beispielsweise mit einem nicht näher bezeichneten Mantel von beispielsweise 10 mm Durchmesser und einer Länge $1 = \lambda_x/4$, wobei $\lambda_x$ die Leitungswellenlänge ist, die beispielsweise für 170 MHz etwa 30 cm beträgt. Neben dieser Ausführungsform eines Koaxialleiters als Parallelresonanzkreis können jedoch auch zwei parallele Leiter verwendet werden, deren Länge und Abstand dann entsprechend bemessen werden.

Gemäß Figur 7 erhält man mit einer Verkürzungskapazität 24 zwischen dem Leiter 84 und Masse einen kapazitiv verkürzten, am Ende kurzgeschlossenen Koaxialleiter 71 als Parallelresonanzkreis. In dieser Ausführungsform wird somit ein Teil der Länge 1 durch die Verkürzungskapazität 24 kompensiert. Der nicht näher bezeichnete Mantel ist wieder an Masse gelegt. Für eine vorbestimmte Resonanzfrequenz $f_0$ gilt für die Größe der Verkürzungskapazität 24:

$$C_{24} = \frac{1}{2\pi f_0 Z_1 . \tan\beta} ;$$

darin ist $Z_1$ die Leitungsimpedanz,

$$\beta = \frac{2\pi l_v}{\lambda_0}$$

und $\lambda_0$ die Leitungswellenlänge bei der Frequenz $f_0$.

Eine besonders vorteilhafte Ausführungsform der Zusammenschaltung zugehöriger Innenleiter, beispielsweise der Innenleiter 4 und 5 für einen Wellenleiterresonator mit den Innenleitern 4 und 5 für beide Resonanzfrequenzen $f_1$ und $f_2$, und ihre Ankopplung über die Eingänge 46 und 47 an jeweils in der Figur nicht dargestellte Sender und Empfänger ist Figur 8 zu entnehmen. Die Innenleiter 4 und 5 sind entsprechend der Darstellung in Figur 4 jeweils über Verkürzungskapazitäten 19 und 20, die nach der hohen Resonanzfrequenz $f_1$ bemessen sind, an Masse gelegt. Außerdem sind die beiden Enden jeweils über eine Reihenschaltung der Verkürzungskapazitäten 10 und 15 mit jeweils einem Sperrkreis 58 bzw. 59 an Masse gelegt. Die Verkürzungskapazitäten 10 und 19 sowie die Impedanz des Sperrkeises 58 bilden gemeinsam die Verkürzungskapazität für die tiefe Resonanzfrequenz $f_2$. In gleicher Weise bilden die Verkürzungskapazitäten 15 und 20 sowie die Impedanz des Sperrkreises 59 die Verkürzungskapazität für die tiefe Resonanzfrequenz $f_2$. Anfang und Ende des Innenleiters 5 sind in gleicher Weise beschaltet mit Verkürzungskondensatoren 11 und 21 sowie 22 und 23 und nicht näher bezeichneten Sperrkreisen.

Der Anfang des Innenleiters 4 ist über einen Sperrkreis 60 für die Resonanzfrequenz $f_1$, einen Koaxialleiter 72, eine Anpassungskapazität 34 mit dem Eingang 46 verbunden. Der Anfang ist außerdem über einen Sperrkreis 61 für $f_2$, einen Koaxialleiter 75 und eine Anpassungskapazität 35 mit dem Eingang 47 verbunden. In gleicher Weise ist der Anfang des Innenleiters 5 jeweils über Sperrkreise 62 und 63 für $f_1$ bzw. $f_2$ und einen Koaxialleiter 73 bzw. 74 sowie die Anpassungskapazitäten 34 und 35 mit den Eingängen 46 bzw. 47 verbunden. An den Eingang 46 ist vorzugsweise über eine in der Figur nicht dargestellte Sende- und Empfangsweiche ein Sender und ein Empfänger für die tiefe Resonanzfrequenz $f_2$ und an den Eingang 47 ist ebenfalls vorzugsweise über eine Sende- und Empfangsweiche ein Sender und ein Empfänger für die hohe Frequenz $f_1$ angeschlossen. Die Anpassungskapazität 34 ist für die eingespeiste tiefe Resonanzfrequenz $f_2$ von beispielsweise 69 MHz und die Anpassungskapazität 35 ist für die eingespeiste hohe Resonanzfrequenz $f_1$ von beispielsweise 170 MHz bemessen. In einer besonderen Ausführungsform der Anordnung kann den Anpassungskapazitäten 34 und 35 noch jeweils eine zusätzliche Abstimmkapazität 26 bzw. 27 zugeordnet sein. Die Verbindungsleiter zwischen den Anpassungskapazitäten 34 und 35 und den Sperrkreisen 60 bis 63 werden jeweils vorzugsweise als Koaxialleiter ausgeführt, die mit einer Abschirmung versehen sind. Der Längenunterschied zwischen den Koaxialleitern 72 und 73 sowie 74 und 75 beträgt jeweils $\lambda/2$ für die jeweilige Resonanzfrequenz. Die Koaxialleiter 73 und 75 sind somit jeweils um $\lambda/2$ länger als die Leiter 72 bzw. 74. Damit erhält man eine Phasenverschiebung des Stromes I in den Leitern 4 und 5 von 180°. Die elektrische Gesamtlänge der jeweiligen Koaxialleiter soll wenigstens annähernd $\lambda/2$ oder ein Vielfaches davon betragen. Dann wird die Impedanz am Einspeisepunkt des Leiters 4 bzw. 5 in denselben Wert an der Stelle der Anpaßkondensatoren 34 bzw. 35 transformiert. Bei der physikalischen Länge der Leitungen sind die Auswirkungen der Sperrkreise 60 bis 63 zu berücksichtigen.

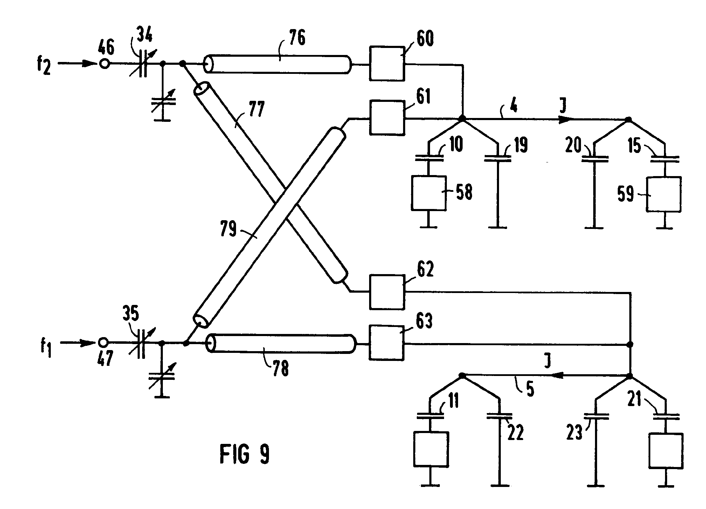

Alternativ kann zur Erzeugung der 180°-Phasenverschiebung der Ströme I auch am Innenleiter 4 vorne und am Innenleiter 5 hinten eingespeist werden, wie es in Figur 9 angedeutet ist. In dieser Ausführungsform wird die tiefe Resonanzfrequenz $f_2$ über die Anpassungskapazität 34 und Koaxialleiter 76 und 77 sowie die Sperrkreise 60 und 62 und die hohe Resonanzfrequenz $f_1$ über die Anpassungskapazität 35 und Koaxialleiter 78 und 79 sowie die Sperrkreise 63 bzw. 61 eingespeist. In diesem Falle erhält man jeweils gleiche Leitungslängen für die Koaxialleiter 76 und 77 sowie 78 und 79.

Eine besonders einfache Ausführungsform der Ankopplung zeigt Figur 10, in der ebenfalls die Innenleiter 4 und 5 mit dem Strom I und die gleiche Anordnung der Verkürzungskondensatoren und Sperrkreise gewählt sind. In dieser Ausführungsform ist der Anfang des Innenleiters 4 über einen Sperrkreis 64 für die Resonanzfrequenz $f_1$ sowie eine Anpassungskapazität 36 mit dem Eingang 46 für die tiefe Resonanzfrequenz $f_2$ verbunden. Der Anfang des Innenleiters 4 ist ferner mit dem Anfang des Innenleiters 5 über eine Leitung verbunden, die mit einer Unterbrechungsstelle S versehen ist, die über einen Sperrkreis 65 für die tiefe Resonanzfrequenz $f_2$ und eine Anpassungskapazität 37 mit dem Eingang 47 für die hohe Frequenz $f_1$ verbunden ist. Den Anpassungskapazitäten 36 und 37 kann vorzugsweise noch jeweils eine nicht näher bezeichnete Abstimmkapazität zugeordnet sein. Durch die Unterbrechungsstelle S werden zwei Leiter 80 und 81 gebildet, deren Längen $l_{80}$ und $l_{81}$ so gewählt sind, daß sich für die tiefe Resonanzfrequenz $f_2$ eine $\lambda/2$-Umwegleitung ergibt. Die Längen der Leiter 80 und 81 werden deshalb so gewählt, daß

$$l_{80} + l_{81} = \frac{\lambda_2}{2}$$

für die tiefe Resonanzfrequenz $f_2$ und

$$l_{80} - l_{81} = \frac{\lambda_1}{2}$$

für die hohe Resonanzfrequenz $f_1$ ergibt. Man erhält somit für die Einspeisung der tiefen Resonanzfrequenz $f_2$ zum Innenleiter 4 eine Direkteinspeisung und zum Innenleiter 5 eine Einspeisung über eine $\lambda_2/2$-Umwegleitung. Für die hohe Resonanzfrequenz $f_1$ werden die Leiter 4 und 5 dagegen über Leitungen mit einem Längenunterschied von $\lambda_1/2$ gespeist. Somit ist wiederum sichergestellt, daß bei beiden Frequenzen die Ströme in den Leiten 4 und 5 um 180° phasenverschoben sind. Für die Summe bzw. die Differenz der Leitungslängen entsprechend diesen Gleichungen können auch ganzzahlige Vielfache N der halben Wellenlänge gewählt werden.

In einer besonders vorteilhaften Ausführungsform kann gemäß Figur 10 der Innenleiter 4 über einen Koaxialleiter 82 mit dem Sperrkreis 64 verbunden sein, dessen Länge $l_{82}$ so gewählt ist, daß die Streukapazität des Sperrkreises 64 gegen Masse am Anfang des Innenleiters 4 bei der hohen Resonanzfrequenz $f_1$ in einen Leerlauf transformiert wird.

In den Ausführungsbeispielen wurden Wellenleiterresonatoren gewählt, die jeweils linear polarisierte Hochfrequenzfelder B erzeugen. Es können jedoch auch Wellenleiterresonatoren vorgesehen sein, die zirkular polarisierte Hochfrequenzfelder B erzeugen. In diesem Falle sind zwei linear polarisierende Wellenleiterresonatoren innerhalb der gemeinsamen Hülle 2 angeordnet, deren Leitersysteme um 90° verdreht sind.

Ist ein Kernspintomograph mit einem Wellenleiterresonator gemäß der Erfindung für allgemein n Resonanzfrequenzen vorgesehen, so werden n Stromzweige an wenigstens einem Ende angeordnet, die n-1 Sperrkreise für die zu sperrenden Resonanzfrequenzen enthalten.

**Patentansprüche**

1. Kernspintomograph mit einer einen Ganzkörper-Wellenleiterresonator bildenden Hochfrequenzantenne, die eine hochfrequenzdichte und niederfrequenzdurchlässige zylindrische Hülle (2) enthält, welche wenigstens ein Paar sich parallel zur Zylinderachse erstreckender, als Induktivitäten bei gleicher Resonanzfrequenz wirkender Innenleiter (4 bis 7) umgibt, die von entgegengesetzten Strömen (J) durchflossen sind, gekennzeichnet durch folgende Merkmale der Hochfrequenzantenne :

    a) der Wellenleiterresonator ist für mehrere Resonanzfrequenzen ($f_1$, $f_2$) ausgelegt,

    b) für jede Resonanzfrequenz ($f_1$, $f_2$) ist ein eigener Eingang des Wellenleiterresonators vorgesehen, der von dem mindestens einen weiteren Eingang für die mindestens eine weitere Resonanzfrequenz ($f_2$ oder $f_1$) entkoppelt ist,

    c) jeder Innenleiter (4 bis 7) ist für mindestens eine Resonanzfrequenz ($f_1$ oder $f_2$) aktiv ,

    d) jeder Innenleiter (4 bis 7) weist an seinen beiden Enden eine der Anzahl seiner Resonanzfrequenzen ($f_1$, $f_2$) entsprechende Anzahl von zur Masse führenden Stromzweigen mit jeweils mindestens einer die jeweilige Resonanzfrequenz ($f_1$ oder $f_2$) mitbestimmenden Verkürzungskapazität (10 bis 13) auf,

    e) mindestens einer dieser Stromzweige enthält einen Sperrkreis (50 bis 53) für die Resonanzfrequenz ($f_2$ bzw, $f_1$) eines der anderen Stromzweige.

2. Kernspintomograph nach Anspruch 1, **dadurch gekennzeichnet**, daß am Anfang und am Ende jedes Innenleiters (4 bis 7) ein Stromzweig abgeht und daß die in diesen beiden Stromzweigen angeordneten Sperrkreise (50 bis 53) bei derselben Resonanzfrequenz sperren.

3. Kernspintomograph nach Anspruch 2 für sehr unterschiedliche Resonanzfrequenzen, **dadurch gekennzeichnet**, daß wenigstens zwei bei verschiedenen Resonanzfrequenzen ($f_1$, $f_2$) aktive Paare von Innenleitern (4, 5 bzw. 6, 7) vorgesehen sind und die Innenleiter (6, 7) des Paares für die höhere Resonanzfrequenz ($f_1$) jeweils mit wenigstens einer zusätzlichen Verkürzungskapazität (14) versehen sind.

4. Kernspintomograph nach Anspruch 2, **dadurch gekennzeichnet**, daß das wenigstens eine Paar von Innenleitern (8) für verschiedene Resonanzfrequenzen ($f_1$, $f_2$) ausgelegt ist.

5. Kernspintomograph nach Anspruch 4, **dadurch gekennzeichnet**, daß jeder Innenleiter (8) eines Paares mehrere Verkürzungskapazitäten enthält.

6. Kernspintomograph nach Anspruch 1, **dadurch gekennzeichnet**, daß

    - das wenigstens eine Paar von Innenleitern (8) für zwei verschiedene Frequenzen ($f_1$, $f_2$) ausgelegt ist,

    - vom Anfang und Ende jedes dieser Innenleiter (8) jeweils ein erster und ein zweiter Stromzweig abgehen,

    - die beiden ersten Stromzweige jeweils über mindestens eine Verkürzungskapazität (19, 20) für die höhere Resonanzfrequenz $f_1$ auf Masse gelegt sind

und

    - die beiden zweiten Stromzweige über jeweils mindestens eine weitere Verkürzungskapazität und über mindestens einen auf die höhere Resonanzfrequenz $f_1$ abgestimmten Sperrkreis auf Masse gelegt sind,

wobei die in den vom Anfang und Ende jedes Innenleiters (8) abgehenden Stromzweigen angeordneten Verkürzungskapazitäten zusammen jeweils die Verkürzungskapazität für die geringere Resonanzfrequenz $f_2$ bilden.

7. Kernspintomograph nach Anspruch 1, **gekennzeichnet** durch einen Parallelschwingkreis als Sperrkreis (50 bis 65) für die jeweils zu sperrende

Resonanzfrequenz ($f_1$ oder $f_2$).

8.  Kernspintomograph nach Anspruch 7, **dadurch gekennzeichnet**, daß der Sperrkreis aus einem am Ende kurzgeschlossenen $\lambda/4$-Koaxialleiter (70) besteht.

9.  Kernspintomograph nach Anspruch 7, **dadurch gekennzeichnet**, daß der Sperrkreis einen am Ende kurzgeschlossenen Koaxialleiter (71) enthält, dessen Länge $l_v$ kleiner als $\lambda/4$ ist und bei dem am Eingang eine Verkürzungskapazität (24) zwischen dem Leiter (84) und Masse angeordnet ist.

10. Kernspintomograph nach Anspruch 1, **dadurch gekennzeichnet**, daß die Innenleiter (4, 5) jeweils über eine Reihenschaltung eines Sperrkreises (60 bzw. 62) mit einem Koaxialleiter (72 bzw. 73) und einer Anpassungskapazität (34) an einen Eingang (46) und über eine Reihenschaltung eines Sperrkreises (61 bzw. 63) mit einem Koaxialleiter (75 bzw. 74) sowie eine Anpassungskapazität (35) an einen zweiten Eingang (47) angeschlossen sind und daß die Längen der Koaxialleiter (72 und 73 bzw. 74 und 75), welche an den gleichen Eingang (46 bzw. 47) angeschlossen sind, sich um die halbe Wellenlänge $\lambda/2$ eines angeschlossenen Senders unterscheiden.

11. Kernspintomograph nach Anspruch 1, **dadurch gekennzeichnet**, daß der Anfang des einen Innenleiters (4) und das Ende des zweiten Innenleiters (5) eines Paars von Innenleitern jeweils über eine Reihenschaltung eines Sperrkreises (60 bzw. 62) mit einem Koaxialleiter (76 bzw. 77) und einer Anpassungskapazität (34) an einen Eingang (46) und über eine gleiche Reihenschaltung eines Sperrkreises (61 bzw. 63) mit einem Koaxialleiter (79 bzw. 78) und einer Anpassungskapazität (35) an einen zweiten Eingang (47) angeschlossen sind.

12. Kernspintomograph nach Anspruch 1 mit einem Wellenleiterresonator für eine hohe Resonanzfrequenz $f_1$ und eine tiefe Resonanzfrequenz $f_2$, **dadurch gekennzeichnet**, daß ein Innenleiter (4) eines Paars von Innenleitern über einen Sperrkreis (64) für die hohe Resonanzfrequenz $f_1$ und eine Anpassungskapazität (36) an einen Eingang (46) für die tiefe Resonanzfrequenz $f_2$ angeschlossen ist, und daß die beiden Innenleiter (4 und 5) über eine auf die tiefe Resonanzfrequenz $f_2$ abgestimmte $\lambda_2/2$-Leitung (80, 81) miteinander verbunden sind, die mit einer Unterbrechungsstelle (S) versehen ist, die über einen Teil (80) der $\lambda_2/2$-Leitung mit der Länge $l_{80}$ mit dem ersten Innenleiter (4) und über den anderen Teil (81) der

$\lambda_2/2$-Leitung mit der Länge $l_{81}$ mit dem zweiten Innenleiter (5) verbunden ist, wobei die Längendifferenz $l_{80}-l_{81}$ gleich der halben Wellenlänge $\lambda_1/2$ der hohen Resonanzfrequenz $f_1$ ist, und daß die Unterbrechungsstelle (S) über einen Sperrkreis (65) für die tiefe Resonanzfrequenz $f_2$ sowie eine Anpassungskapazität (37) an einen Eingang (47) für die hohe Resonanzfrequenz $f_1$ angeschlossen ist.

## Claims

1.  Nuclear spin tomograph having a high-frequency antenna which forms a whole-body waveguide resonator and contains a cylindrical sheath (2) which is opaque to high frequency and transmits low frequency and surrounds at least one pair of inner conductors (4 to 7) which extend parallel to the cylinder axis, act as inductors given equal resonant frequency and through which opposing currents (J) flow, characterised by the following features of the high-frequency antenna:
    a) the waveguide resonator is designed for a plurality of resonant frequencies ($f_1$, $f_2$),
    b) provided for each resonant frequency ($f_1$, $f_2$) there is an input of the waveguide resonator that is peculiar thereto and decoupled from the at least one further input for the at least one further resonant frequency ($f_2$ or $f_1$),
    c) each inner conductor (4 to 7) is active for at least one resonant frequency ($f_1$ or $f_2$),
    d) each inner conductor (4 to 7) has at its two ends a number of current branches corresponding to the number of its resonant frequencies ($f_1$, $f_2$), which current branches conduct to earth and have in each case at least one shortening capacitor (10 to 13) co-determining the respective resonant frequency ($f_1$ or $f_2$),
    e) at least one of these current branches contains a block circuit (50 to 53) for the resonant frequency ($f_2$ or $f_1$ respectively) of one of the other current branches.

2.  Nuclear spin tomograph according to claim 1, characterised in that one current branch goes off at the beginning and at the end of each inner conductor (4 to 7) and in that the block circuits (50 to 53) arranged in these two current branches block given the same resonant frequency.

3.  Nuclear spin tomograph according to claim 2 for very different resonant frequencies, characterised in that at least two pairs of inner conductors (4, 5 and 6, 7), which are active at different resonant frequencies ($f_1$, $f_2$), are provided and the inner conductors (6, 7) of the pair for the higher res-

onant frequency ($f_1$) are each provided with at least one additional shortening capacitor (14).

4. Nuclear spin tomograph according to claim 2, characterised in that the at least one pair of inner conductors (8) is designed for different resonant frequencies ($f_1$, $f_2$).

5. Nuclear spin tomograph according to claim 4, characterised in that each inner conductor (8) of a pair contains a plurality of shortening capacitors.

6. Nuclear spin tomograph according to claim 1, characterised in that
   - the at least one pair of inner conductors (8) is designed for two different frequencies ($f_1$, $f_2$),
   - a first current branch and a second current branch in each case go off from the beginning and end of each of these inner conductors (8),
   - the two first current branches are each connected to earth by way of at least one shortening capacitor (19, 20) for the higher resonant frequency $f_1$,
   and
      - the two second current branches are connected to earth by way of, in each case, at least one further shortening capacitor and by way of at least one block circuit which is tuned to the higher resonant frequency $f_1$,
   with the shortening capacitors, which are arranged in the current branches going off from the beginning and end of each inner conductor (8), together respectively forming the shortening capacitor for the lower resonant frequency $f_2$.

7. Nuclear spin tomograph according to claim 1, characterised by a parallel resonant circuit as a block circuit (50 to 65) for the respective resonant frequency ($f_1$ or $f_2$) to be blocked.

8. Nuclear spin tomograph according to claim 7, characterised in that the block circuit consists of a $\lambda/4$ coaxial conductor (70) which is shorted at the end.

9. Nuclear spin tomograph according to claim 7, characterised in that the block circuit contains a coaxial conductor (71) which is shorted at the end and the length $l_v$ of which is less than $\lambda/4$ and in which, at the input, a shortening capacitor (24) is arranged between the conductor (84) and earth.

10. Nuclear spin tomograph according to claim 1, characterised in that the inner conductors (4, 5) are each connected to one input (46) by way of a series circuit arrangement of a block circuit (60 and 62 respectively) with a coaxial conductor (72 and 73 respectively) and a matching capacitor (34) and to a second input (47) by way of a series circuit arrangement of a block circuit (61 and 63 respectively) with a coaxial conductor (75 and 74 respectively) and also a matching capacitor (35) and in that the lengths of the coaxial conductors (72 and 73, and 74 and 75 respectively), which are connected to the same input (46 and 47 respectively), differ by half the wavelength $\lambda/2$ of a connected transmitter.

11. Nuclear spin tomograph according to claim 1, characterised in that the beginning of the one inner conductor (4) and the end of the second inner conductor (5) of a pair of inner conductors are each connected to an input (46) by way of a series circuit arrangement of a block circuit (60 and 62 respectively) with a coaxial conductor (76 and 77 respectively) and a matching capacitor (34) and to a second input (47) by way of a similar series circuit arrangement of a block circuit (61 and 63 respectively) with a coaxial conductor (79 and 78 respectively) and a matching capacitor (35).

12. Nuclear spin tomograph according to claim 1 having a waveguide resonator for a high resonant frequency $f_1$ and a low resonant frequency $f_2$, characterised in that an inner conductor (4) of a pair of inner conductors is connected to an input (46) for the low resonant frequency $f_2$ by way of a block circuit (64) for the high resonant frequency $f_1$ and a matching capacitor (36) and in that the two inner conductors (4 and 5) are connected with each other by way of a $\lambda_2/2$-line (80, 81) which is tuned to the low resonant frequency $f_2$ and is provided with a point of interruption (S) which is linked with the first inner conductor (4) by way of a portion (80) of the $\lambda_2/2$-line having the length $l_{80}$ and is linked with the second inner conductor (5) by way of the other portion (81) of the $\lambda_2/2$-line having the length $l_{81}$, with the difference in lengths $l_{80}-l_{81}$ being equal to half the wavelength $\lambda_1/2$ of the high resonant frequency $f_1$, and in that the point of interruption (S) is connected to an input (47) for the high resonant frequency $f_1$ by way of a block circuit (65) for the low resonant frequency $f_2$ and also a matching capacitor (37).

**Revendications**

1. Tomographe par spins nucléaires avec une antenne haute fréquence formant un résonateur à guide d'ondes pour le corps entier qui contient une gaine (2) cylindrique hermétique aux hautes fréquences et perméable au basses fréquences, enveloppant au moins une paire de conducteurs intérieurs (4 à 7) agissant, comme inductances à la même fréquence de résonance, traversés par des courants opposés (J) et s'étendant parallèlement à l'axe du cylindre, caractérisé par les caractéristiques suivantes de l'antenne à haute fréquence:

a) le résonateur à guide d'ondes est conçu pour plusieurs fréquences de résonance $(f_1, f_2)$,

b) pour chaque fréquence de résonance $(f_1, f_2)$, il est prévu une entrée particulière du résonateur à guide d'ondes qui est découplée d'au moins une autre entrée pour au moins une autre fréquence de résonance $(f_2$ ou $f_1)$,

c) chaque conducteur intérieur (4 à 7) est actif pour au moins une fréquence de résonance $(f_1$ ou $f_2)$,

d) chaque conducteur intérieur (4 à 7) présente à ses deux extrémités un nombre de dérivations conduisant à la masse, correspondant au nombre de ses fréquences de résonance $(f_1, f_2)$, chaque dérivation présentant au moins une capacité de raccourcissement (10 à 13) déterminant simultanément la fréquence de résonance respective $(f_1$ ou $f_2)$,

e) une de ces dérivations au moins contient un circuit bouchon (50 à 53) pour la fréquence de résonance $(f_2$ resp. $f_1)$ de l'une des autres dérivations.

2. Tomographe par spins nucléaires selon la revendication 1 caractérisé en ce qu'une dérivation part du début et de la fin de chaque conducteur intérieur (4 à 7) et en ce que les circuits bouchons (50 à 53) montés dans ces deux dérivations, bloquent à la même fréquence de résonance.

3. Tomographe par spins nucléaires selon la revendication 2 pour des fréquences de résonance très différentes, caractérisé en ce qu'au moins deux paires de conducteurs intérieurs (4, 5 ou 6, 7), actives à différentes fréquences de résonance $(f_1, f_2)$ sont prévues et en ce que les conducteurs intérieurs (6, 7) de la paire pour la fréquence de résonance supérieure $(f_1)$ sont dotés chacun d'au moins une capacité de raccourcissement supplémentaire (14).

4. Tomographe par spins nucléaires selon la revendication 2 caractérisé en ce que la - au moins une - paire de conducteurs intérieurs (8) est conçue pour différentes fréquences de résonance $(f_1, f_2)$.

5. Tomographe par spins nucléaires selon la revendication 4, caractérisé en ce que chaque conducteur intérieur (8) d'une paire contient plusieurs capacités de raccourcissement.

6. Tomographe par spins nucléaires selon la revendication 1, caractérisé
   - en ce que la - au moins une - paire de conducteurs intérieurs (8) est conçue pour deux fréquences différentes $(f_1, f_2)$,
   - en ce qu'au début et à la fin de chacun de ces conducteurs intérieurs (8) partent à chaque fois une première et une deuxième dérivation,
   - en ce que les deux premières dérivations sont mises à la masse à chaque fois par au moins une capacité de raccourcissement (19, 20) pour la fréquence de résonance supérieure $f_1$ et
   - en ce que les deux secondes dérivations sont mises à la masse à chaque fois par au moins une autre capacité de raccourcissement et par au moins un circuit bouchon réglé sur la fréquence de résonance supérieure $f_1$,

les capacités de raccourcissement montées dans les dérivations partant du début et de la fin de chaque conducteur intérieur (8) formant ensemble à chaque fois la capacité de raccourcissement pour la fréquence de résonance plus faible $f_2$.

7. Tomographe par spins nucléaires selon la revendication 1 caractérisé par un circuit oscillant parallèle en tant que circuit bouchon (50 à 65) pour la fréquence de résonance $(f_1$ ou $f_2)$ respective à bloquer.

8. Tomographe par spins nucléaires selon la revendication 7, caractérisé en ce que le circuit bouchon est composé d'un conducteur coaxial $\lambda/4$ (70) court-circuité à l'extrémité.

9. Tomographe par spins nucléaires selon la revendication 7, caractérisé en ce que le circuit bouchon contient un conducteur (71) court-circuité à une extrémité dont la longueur $l_v$ est inférieure à $\lambda/4$ et pour lequel une capacité de raccourcissement (24) est montée à l'entrée entre le conducteur (84) et la masse.

10. Tomographe par spins nucléaires selon la revendication 1, caractérisé en ce que les conducteurs intérieurs (4, 5) sont connectés à chaque fois à une entrée (46) par un montage en série d'un circuit bouchon (60 resp. 62) avec un conducteur coaxial (72 resp. 73) et une capacité d'adaptation (34) et à une deuxième entrée (47) par un montage en série d'un circuit bouchon (61 resp. 63) avec un conducteur coaxial (75 resp. 74) ainsi qu'une capacité d'adaptation (35) et en ce que les longueurs des conducteurs coaxiaux (72 et 73 resp. 74 et 75), branchés à la même entrée (46 resp. 47), sont différenciées par la moitié de la longueur d'ondes λ/2 d'un émetteur connecté.

11. Tomographe par spins nucléaires selon la revendication 1, caractérisé en ce que le début de l'un (4) des conducteurs intérieurs et la fin du deuxième conducteur intérieur (5) d'une paire de conducteurs intérieurs, sont connectés respectivement à une entrée (46) par un montage en série d'un circuit bouchon (60 resp. 62) avec un conducteur coaxial (76 resp. 77) et une capacité d'adaptation (34) et à une deuxième entrée (47) par un montage en série identique d'un circuit bouchon (61 resp. 63) avec un conducteur coaxial (79 resp. 78) et une capacité d'adaptation (35).

12. Tomographe par spins nucléaires selon la revendication 1, avec un résonateur à guide d'ondes pour une fréquence de résonance élevée $f_1$ et une fréquence de résonance basse $f_2$, caractérisé en ce qu'un conducteur intérieur (4) d'une paire de conducteurs intérieurs est connecté à une entrée (46) pour la fréquence de résonance basse $f_2$ par un circuit bouchon (64) pour la fréquence de résonance élevée $f_1$ et par une capacité d'adaptation (36) et en ce que les deux conducteurs intérieurs (4 et 5) sont reliés entre eux par une liaison $\lambda_2/2$ (80, 81) réglée sur la fréquence de résonance basse $f_2$, dotée d'un point d'interruption (S) qui est relié au premier conducteur intérieur (4) par une partie (80) de la liaison $\lambda_2/2$ avec la longueur $l_{80}$ et au deuxième conducteur intérieur (5) par l'autre partie (81) de la liaison $\lambda_2/2$ avec la longueur $l_{81}$, la différence de longueur $l_{80}-l_{81}$ étant égale à la demi longueur d'onde $\lambda_1/2$ de la fréquence de résonance élevée $f_1$ et en ce que le point d'interruption (S) est connecté à une entrée (47) pour la fréquence de résonance élevée $f_1$ par un circuit bouchon (65) pour la fréquence de résonance basse $f_2$ et par une capacité d'adaptation (37).

EP 0 389 868 B1

FIG 1

FIG 2

FIG 3

FIG 4

11

FIG 5

FIG 6

FIG 7

FIG 8

FIG 10

FIG 9